# EUROPEAN PATENT APPLICATION

(11) **EP 4 580 062 A1**
(43) Date of publication of application: **02.07.2025**
(21) Application number: 24215650.3
(22) Date of filing: 27.11.2024
(51) Int. Cl.: H03K 17/96, H03K 17/975

(54) **OPERATING DEVICE**

(30) Priority: 25.12.2023 JP 2023218093
(71) Applicant: TOYO DENSO KABUSHIKI KAISHA, Minato-ku Tokyo 105-0004 (JP)
(72) Inventor: KOJIMA, Tsurugi, Saitama, 350-2280 (JP); UDA, Takeshi, Saitama, 350-2280 (JP); TAKEUCHI, Hiroki, Saitama, 350-2280 (JP); GOTO, Kenta, Saitama, 350-2280 (JP)
(74) Representative: Betten & Resch

(57) **Abstract**

An operating device of the present disclosure includes: an operating unit placed apart from a substrate and pressed and operated by a user; a first elastic member placed in abutment on the substrate and the operating unit therebetween, having a spaced portion formed apart from the substrate, and deforming so that the spaced portion moves toward the substrate as a result that the operating unit is pressed and operated; an electroconductive second elastic member on a surface facing the substrate of the spaced portion of the first elastic member, abutting on the substrate and deforming as a result that the operating unit is pressed and operated and the spaced portion moves toward the substrate; an electrode provided on the substrate and generating capacitance with the second elastic member; and a detecting unit detecting the capacitance generated on the electrode and accepting an operation corresponding to a detected capacitance value.

## Description

### INCORPORATION BY REFERENCE

This application is based upon and claims the benefit of priority from Japanese patent application No. 2023-218093, filed on December 25, 2023, the disclosure of which is incorporated herein in its entirety by reference.

### TECHNICAL FIELD

The present disclosure relates to a capacitive operating device.

### BACKGROUND ART

An example of an operating device mounted in a vehicle is a capacitive input device as described in Patent Literature 1. The input device described in Patent Literature 1 is placed so that the key top of an operating button is exposed through an opening of a protective panel formed on a substrate, and is configured to include a second electrode placed between the protective panel and the key top and a first electrode placed on the substrate on the inner side of the operating button. Consequently, the input device described in Patent Literature 1 first detects an intermediate operating state in which the key top of the operating button is pressed with a finger based on the capacitance of the second electrode, and then detects a final operating state in which the key top is fully pressed with the finger based on the capacitance of the first electrode. Thus, the input device of Patent Literature 1 detects two stages of pressing operations with a finger.

### Patent Literature 1: Japanese Patent Publication No. 7125922

However, the input device of Patent Literature 1 described above needs to include a plurality of electrodes different from each other such as the first electrode and the second electrode. As a result, the number of fixtures increases, which causes problems such as complexity of configuration and increase of cost.

### SUMMARY OF THE INVENTION

Accordingly, an object of the present disclosure is to solve complexity of configuration and increase of cost pertaining to a capacitive operating device.

An operating device as an aspect of the present disclosure includes: an operating unit placed apart from a substrate, the operating unit being pressed and operated by a user; a first elastic member placed in abutment on the substrate and the operating unit between the substrate and the operating unit, the first elastic member having a spaced portion formed apart from the substrate, the first elastic member deforming so that the spaced portion moves toward the substrate as a result that the operating unit is pressed and operated; an electroconductive second elastic member on a surface facing the substrate of the spaced portion of the first elastic member, the second elastic member abutting on the substrate and deforming as a result that the operating unit is pressed and operated and the spaced portion moves toward the substrate; an electrode provided on the substrate, the electrode generating capacitance with the second elastic member; and a detecting unit detecting the capacitance generated on the electrode and accepting an operation corresponding to a detected value of the capacitance.

Configured as described above, the present disclosure enables simplification of configuration and reduction of cost pertaining to a capacitive operating device.

### BRIEF DESCRIPTION OF DRAWINGS

Fig. 1 is a view showing the appearance of an operating device in the present disclosure;
Fig. 2 is a cross-sectional view of the operating device and a view showing the state of the operation thereof in the present disclosure;
Fig. 3 is a view showing the state of capacitance that may be generated in the operating device in the present disclosure; and
Fig. 4 is a view showing an example of capacitance that may be generated in the operating device and load on the operating device in the present disclosure.

### EXAMPLE EMBODIMENT

### <First Example Embodiment>

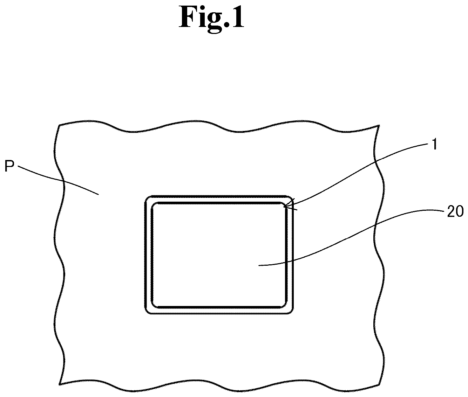

A first example embodiment of the present disclosure will be described with reference to Figs. 1 to 4.

As shown in Fig. 1, an operating device 1 in this example embodiment is a push-button type operating device 1 provided on a predetermined panel P such as an instrument panel of an automobile, which is a vehicle. Fig. 1 illustrates only part the panel P. In particular, the operating device 1 in this example embodiment is a capacitive operating device and, as will be described below, is configured so that capacitance that may be generated changes with an operating state such as whether a finger of a user gets close to, touches, or presses a key top 20 serving as an operating unit of the operating device, and accepts different operations in accordance with change of the capacitance. The operating device may be installed at any place in the vehicle, and may be installed in any device or equipment, not limited to the vehicle.

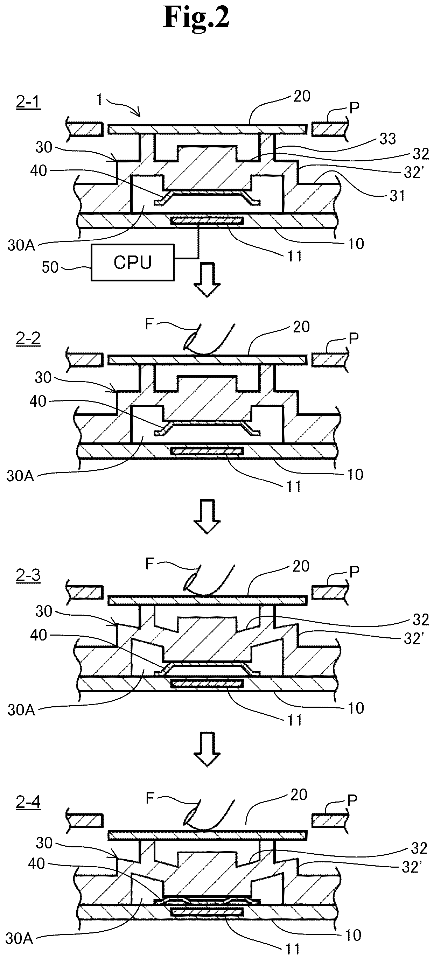

Fig. 2 shows a cross-sectional view of the operating device 1 seen from the side. As shown in Fig. 2(2-1), the operating device 1 includes a substrate 10 placed on the inside of a panel P, a key top 20 exposed to the outside through an opening of the panel P, a rubber 30 placed between the substrate 10 and the key top 20, and a metal dome 40 placed between the substrate 10 and the rubber 30. The respective components and the operation thereof will be described below.

The substrate 10 is installed on the inside of the panel P, that is, in the vehicle, and various electronic components are mounted thereon. Then, a processor such as a CPU (Central Processing Unit) 50 is connected to the substrate 10, and the CPU 50 functions to detect signals from the electronic components mounted on the substrate 10 and to output signals to the electronic components. In this example embodiment, as will be described later, in particular, the substrate 10 is provided with an electrode 11, which functions to generate a capacitance with the metal dome 40, and the CPU 50 is configured to detect the capacitance. The metal dome 40 and the CPU 50 will be described later. Moreover, illustration of the CPU 50 is omitted in Figs. 2(2-2) to 2(2-4).

The key top 20 (operating unit) is a flat member made of resin or the like, placed so as to be exposed to the outside through the opening of the panel P as shown in Figs. 1 and 2(2-1). The key top 20 is placed at a distance from the substrate 10, and is supported by the rubber 30, which is placed between the key top 20 and the substrate 10. The surface of the key top 20 exposed to the outside forms an operating surface that is pressed and operated from the outside of the panel P toward the inside by a user's finger F.

The rubber 30 (first elastic member) is an elastic member such as rubber that is placed in abutment on and between the substrate 10 and the key top 20. In this example embodiment, the rubber 30 is formed in a substantially bowl shape with a side close to the substrate 10 being open. Specifically, as shown in Fig. 2(2-1), the rubber 30 has an annular base part 31 with a predetermined thickness that is located on the open side of the substantially bowl shape and abuts on the substrate 10, and a substantially circular lid part 32 that is connected to the base part 31 and covers a side close to the key top 20 of the central region of the base part 31. That is to say, the rubber 30 is formed by connecting the substantially circular lid part 32 so as to cover the side close to the key top 20 of the annular base part 31 abutting on the substrate 10. Consequently, the lid part 32 forms a spaced portion located away from the substrate 10, and an internal space 30A is formed between the substrate 10 and an inner surface side of the lid part 32 located opposite the key top 20 side. The internal space 30A is surrounded on its sides by the base part 31. Moreover, the rubber 30 has a substantially annular support part 33 that abuts on the key top 20 and supports the key top 20, on a side closer to the key top 20 than the lid part 32.

The rubber 30 is configured as described above, so that when the key top 20 is pressed and operated by the user's finger F toward the substrate 10 as shown in Fig. 2(2-2), the lid part 32 deforms so as to move toward the substrate 10 as shown in Figs. 2(2-3) and (2-4). Specifically, in the rubber 30, when the key top 20 is pressed by the finger F, a pressing force is transmitted to the lid part 32 via the support part 33 supporting the key top 20, a connection portion 32' with the base part 31 located around the lid part 32 is elastically deformed by the pressing force, and the lid part 32 moves toward the substrate 10. In addition, since the rubber 30 is formed of an elastic member such as rubber, the rubber 30 is configured to generate resilience against deformation. Therefore, when the pressing force by the finger F described above is released, the elastic deformation of the connection portion 32' of the lid part 32 with the base part 31 restores, and the lid part 32 located on the substrate 10 side moves toward the key top 20 side, returning to its original shape.

The metal dome 40 (second elastic member) is formed in a dome shape that opens toward the substrate, and is formed of a metal leaf spring. Since the metal dome 40 is thus formed of an elastic member having resilience such as a leaf spring, the metal dome 40 is configured so that when a convex portion located opposite the opening side of the dome shape is pressed toward the opening, the convex portion is deformed so as to dent toward the opening and, when the pressure is released, the convex portion having dented returns to its original shape. Consequently, it is possible to obtain a tactile feeling when operating the key top 20. The metal dome 40 is placed in the internal space 30A formed between the rubber 30 and the substrate 10 described above, and the convex portion opposite the opening side of the dome shape is installed on the inner surface side of the lid part 32, that is, on the surface of the lid part 32 facing the substrate 10. Then, since the length from the opening side to the convex portion of the metal dome 40 is shorter than the length of the internal space 30A formed between the rubber 30 and the substrate 10, the opening side of the metal dome 40 is located away from the substrate 10.

The metal dome 40 is configured as described above, so that when the key top 20 is pressed and operated toward the substrate 10 by the user's finger F as shown in Fig. 2(2-2), along with the movement of the lid part 32 of the rubber 30 toward the substrate 10 described above, the metal dome 40 moves toward the substrate 10 and the opening side abuts on the substrate 10 and furthermore the convex portion deforms so as to dent as shown in Figs. 2(2-3) and 2(2-4). Specifically, when the key top 20 is pressed by the finger F, the metal dome 40 installed on the inner surface of the lid part 32 of the rubber 30 moves toward the substrate 10 together with the lid part 32, and the opening side of the metal dome 40 abuts on the substrate 10 as shown in Fig. 2(2-3). After that, when the key top 20 is further pressed by the finger F, the lid part 32 of the rubber 30 further moves toward the substrate 10, and the convex portion of the metal dome 40 deforms so as to dent toward the substrate 10 as shown in Fig. 2(2-4). Since the metal dome 40 is formed of an elastic member such as a leaf spring, it is configured to generate resilience against deformation. Therefore, when the abovementioned pressing force by the finger F is released, the metal dome 40 returns to its original shape from the state in which the convex portion dents. This example embodiment illustrates a case where the metal dome 40 is made of metal, but the metal dome 40 may be formed of any member as far as it is a conductive member.

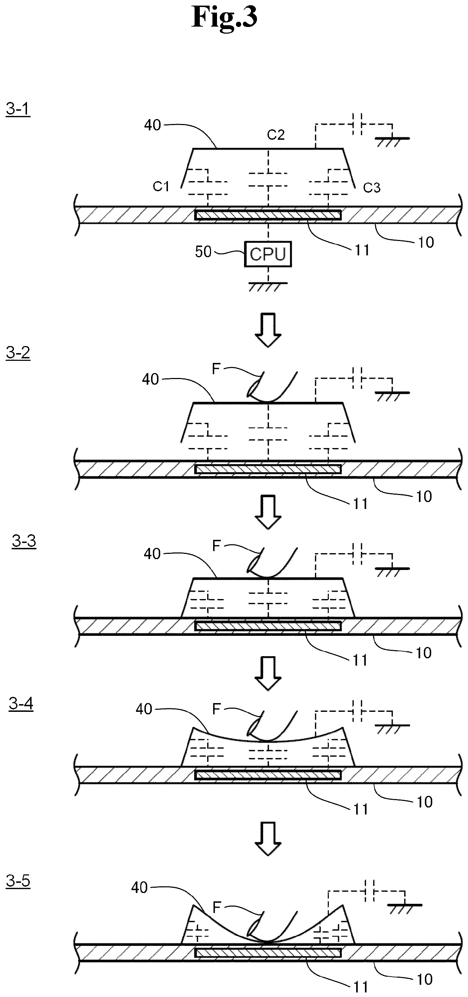

As described above, the electrode 11 is provided on the substrate 10 so as to correspond to the placement of the metal dome 40 described above. Specifically, as shown in Fig. 2(2-3), the electrode 11 is provided inside the substrate 10 near a place in which the metal dome 40 abuts on when the key top 20 moves due to the pressure by the finger F and the metal dome 40 moves so as to abut on the substrate 10. This brings a state where capacitors C1, C2, and C3 as shown in Fig. 3(3-1) are formed between the metal dome 40 and the electrode 11, and capacitance is generated by these capacitors C1, C2, and C3. Reference symbols C1 and C3 denote capacitors that can be formed near both the ends of the metal dome 40, and reference symbol C2 denotes a capacitor that can be formed near the center of the metal dome 40.

Then, the CPU 50 is connected to the electrode 11 as described above, so that the CPU 50 (detecting unit) detects capacitance that can be generated by the electrode 11 and accepts a user's operation corresponding to the detected capacitance value. The function of the CPU 50 in this example embodiment can be realized by execution of a predetermined program by the CPU.

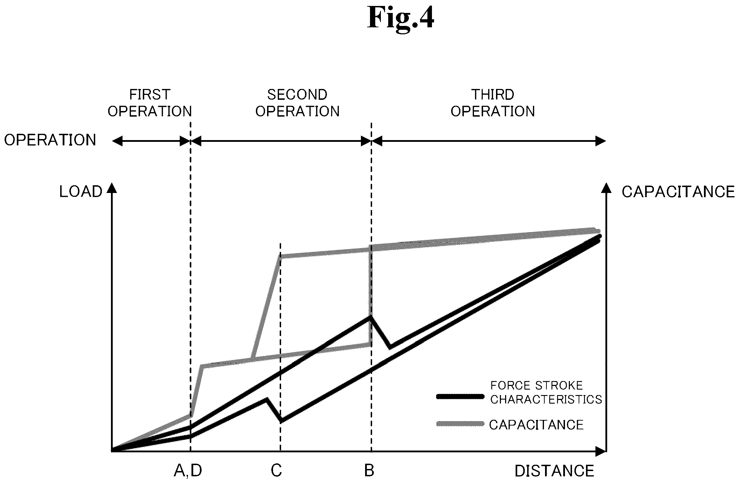

Here, the behavior of the operating device corresponding to an operation by the user's finger F and the reception of the operation by the CPU 50 will be described with reference to Figs. Figs. 2 to 4 Fig. 3 shows a positional relation between the metal dome 40 and the substrate 10 when the operating device is operated. In illustration of Fig. 3, part of the configuration of the operating device is omitted. Fig. 4 shows the value of capacitance detected when the operating device is operated and load by pressure. In Fig. 4, the horizontal axis represents the moving distance of the metal dome 40, and the vertical axis represents the load by the finger F and the capacitance.

First, in a state shown in Figs. 2(2-1) and 3(3-1), that is, in a case where the finger F is not close to or in contact with the key top 20, the CPU 50 detects a reference value with capacitance 0 and determines to be an unoperated state. After that, in a state shown in Figs. 2(2-2) and 3(3-2) to Figs. 2(2-3) and 3(3-3), that is, in a case where the user brings the finger F close to or in contact with the key top 20 or performs an operation such as pressing the key top 20 until just before the metal dome 40 abuts on the substrate 10, the CPU 50 detects a first change value from the reference value of capacitance and accepts it as a first operation. That is to say, in this case, as a result that the finger F comes close to or in contact with the key top 20 and the metal dome 40 comes close to the substrate 10, the capacitance of the capacitors C1, C2, and C3 between the metal dome 40 and the electrode 11 gradually increases, and this value is detected as being distinct from the reference value that is a value in the unoperated state. At this time, the value of capacitance when the metal dome 40 abuts on the substrate 10 is measured in advance, and a value around the measured value (for example, a value equal to or lower than the measured value) is set in the CPU 50 as a first threshold value. Consequently, as shown in Fig. 4, when the moving distance of the metal dome 40 is within a section denoted by symbol A, that is, until the metal dome 40 abuts on the substrate 10, the CPU 50 detects the first change value of capacitance that is greater than the reference value set to 0 but does not exceed the first threshold value, and accepts it as the first operation. In addition, at this time, the user obtains an operational feeling as if the user is close to or in contact with the key top 20 or as if the user is in contact with and then pressing the key top 20.

After that, in a state shown in Figs. 2(2-3) and 3(3-3), that is, in a case where the key top 20 is pressed by the finger F and an operation such as bringing the metal dome 40 in contact with the substrate 10 is performed, the CPU 50 detects a second change value of capacitance that is even greater than the abovementioned first threshold value, and accepts it as a second operation. That is to say, in this case, as a result that the metal dome 40 comes closer to the substrate 10, the capacitance of the capacitors C1, C2, and C3 between the metal dome 40 and the electrode 11 further increases, and the second change value that is greater than or equal to the first threshold value is detected as being distinct from the value in the first operating state described above. At this time, the value of capacitance when the metal dome 40 deforms and comes closer to the substrate 10 is measured in advance, and a value around the measured value (for example, a value equal to or lower than the measured value) is set in the CPU 50 as the second threshold value. Consequently, as shown in Fig. 4, when the movement distance of the metal dome 40 is within a section from symbol A to symbol B, that is, until the metal dome 40 abuts on the substrate 10 and deforms, the CPU 50 detects the second change value of capacitance that is greater than or equal to the first threshold value and does not exceed the second threshold value, and accepts it as the second operation. In addition, at this time, the user obtains an operational feeling of a half-pressed state in which the user presses the key top 20 to a predetermined depth and receives a reaction force.

After that, in a state shown in Figs. 2(2-4), 3(3-4), and 3(3-5), that is, when an operation such as further pressing the key top 20 with the finger F is performed so that the metal dome 40 abuts on the substrate 10 and the convex portion further dents and deforms, the CPU 50 detects a third change value of capacitance that is even greater than the abovementioned second threshold value, and accepts this as a third operation. That is to say, in this case, as a result that the central part of the metal dome 40 comes closer to the substrate 10, the capacitance between the metal dome 40 and the electrode 11, particularly of the capacitor C2 further increases, and a value equal to or more than the second threshold value is detected as being distinct from the value in the second operating state described above. Consequently, as shown in Fig. 4, in a state where the moving distance of the metal dome 40 is in a section equal to or greater than symbol B, that is, the metal dome 40 deforms, the CPU 50 detects the third change value of capacitance that is equal to or greater than the second threshold value and accepts it as the third operation. In addition, at this time, the user obtains an additional clicking feeling caused by the deformation of the metal dome 40, that is, a tactile operational feeling of further pressing from the half-pressed state.

After that, when the pressing operation by the finger F on the key top 20 is released, the metal dome 40 and the rubber 30 return to their original shapes. That is to say, it returns from the state shown in Figs. 2(2-4), 3(3-4), and 3(3-5) to the state shown in Figs. 2(2-1) and 3(3-1) where the contact of the finger F is released through the state shown in Figs. 2(2-2) and 3(3-2) and then the state shown in Figs. 2(2-3) and 3(3-3). Then, the value of capacitance detected by the CPU 50 returns from a value greater than or equal to the second threshold value described above to the reference value through a value less than the second threshold value (part denoted by symbol C in Fig. 4) and then a value less than the first threshold value (part denoted by symbol D in Fig. 4). Consequently, the CPU 50 determines that the operation is released. In addition, in the process of releasing the operation, an operating position where the detected value is the second change value that is equal to or greater than the first threshold value and less than the second threshold value, that is, an operation to return to the second operation may be performed.

Although a case where the CPU 50 sets the first threshold value and the second threshold value and accepts three different types of operations based on whether or not the detected capacitance value exceeds the respective threshold values has been illustrated above, the CPU 50 may detect the second operation and the third operation based on whether or not the detected capacitance value exceeds the first threshold value and the second threshold value mentioned above, respectively, and accept two different types of operations.

Here, another application example of the abovementioned operating device will be described. The operating device in this application example, in which an operating surface of the key top 20 is formed larger in size, is configured so that not only the pressing operation but also a position input operation on the operating surface can be performed. That is to say, the operating device is configured to be able to also detect the position of the user's finger F on the operating surface of the key top 20 and detect a slide operation or the like. For example, the operating device can detect the position of the finger F by mounting more electrodes 11 on the substrate 10 and detecting capacitance that may be generated in the respective electrodes 11. However, the configuration to detect the position of the finger F on the operating surface of the key top 20 may be realized with any configuration.

Then, an object to be operated with the operating device in this application example is a car navigation system mounted in a vehicle. In this case, first, the user performs an operation of coming in contact with the key top 20 with the finger F. Then, the operating device accepts an operation of turning on the screen of the car navigation system as the abovementioned first operation. Consequently, the screen of the car navigation system lights up or lights up with even more brightness. The first operation may be, for example, an operation of executing another process, such as displaying the menu of the car navigation system.

Next, the user presses the key top 20 with the finger F, and performs a half-press operation of pressing the key top 20 to a predetermined depth at which a reaction force is felt, as described above. Then, the operating device accepts, as the abovementioned second operation, an operation of making a cursor movable on the screen of the car navigation system. Consequently, the cursor is displayed on the screen of the car navigation system, and an operation of moving the cursor is allowed. In this state, the user performs an operation of moving the finger F on the key top 20, so that the cursor on the screen moves. For example, the user can move the cursor over a desired button.

Next, the user further presses the key top 20 with the finger F, and performs the operation of pressing it down until a clicking feeling is obtained as described above. Then, the operating device accepts a selection operation using the cursor on the screen of the car navigation system as the abovementioned third operation. Consequently, the button on which the cursor is located on the screen of the car navigation system is selected, and an operation corresponding to that button is executed.

Although a car navigation system is given as an example of an object to be operated with the operating device of the present disclosure, the object to be operated may be any device, and an operation accepted by the operating device may be any type of operation. Moreover, the operating device of the present disclosure is not limited to being mounted on a vehicle, but may be mounted on any device.

### <Supplementary Notes>

The whole or part of the example embodiments disclosed above can be described as the following supplementary notes. Below, the overview of an operating device according to the present disclosure will be described. However, the present disclosure is not limited to the following configurations.

### (Supplementary Note 1)

An operating device comprising:
an operating unit placed apart from a substrate, the operating unit being pressed and operated by a user;
a first elastic member placed in abutment on the substrate and the operating unit between the substrate and the operating unit, the first elastic member having a spaced portion formed apart from the substrate, the first elastic member deforming so that the spaced portion moves toward the substrate as a result that the operating unit is pressed and operated;
an electroconductive second elastic member on a surface facing the substrate of the spaced portion of the first elastic member, the second elastic member abutting on the substrate and deforming as a result that the operating unit is pressed and operated and the spaced portion moves toward the substrate;
an electrode provided on the substrate, the electrode generating capacitance with the second elastic member; and
a detecting unit detecting the capacitance generated on the electrode and accepting an operation corresponding to a detected value of the capacitance.

### (Supplementary Note 2)

The operating device according to Supplementary Note 1, wherein
the second elastic member is configured to abut on the substrate as a result that the operating unit is pressed and operated and the spaced portion of the first elastic member moves toward the substrate, and deform as a result that the operating unit is then further pressed and operated and the spaced portion further moves toward the substrate.

### (Supplementary Note 3)

The operating device according to Supplementary Note 1 or 2, wherein
the second elastic member is formed of a metal leaf spring and is configured so that the leaf spring deforms as a result that the operating unit is pressed and operated in a state where the second elastic member abuts on the substrate.

### (Supplementary Note 4)

The operating device according to Supplementary Note 1, 2, or 3, wherein
the second elastic member is formed in a dome shape opening toward the substrate.

### (Supplementary Note 5)

The operating device according to any one of Supplementary Notes 1 to 4, wherein
the detecting unit accepts at least two operations in accordance with the detected value of the capacitance.

### (Supplementary Note 6)

The operating device according to any one of Supplementary Notes 1 to 5, wherein
the detecting unit accepts at least two different operations in accordance with whether or not the detected value of the capacitance exceeds a preset threshold value.

### (Supplementary Note 7)

The operating device according to any one of Supplementary Notes 1 to 6, wherein
the detecting unit detects the capacitance in a state where the user is close to or in contact with the operating unit and the second elastic member does not abut on the substrate, the capacitance in a state where the second elastic member abuts on the substrate, and the capacitance in a state where the second elastic member abuts on the substrate and then deforms, as being distinct from each other, and accepts operations different from each other in accordance with the detected values detected as being distinct from each other.

Although the present disclosure has been described above with reference to the example embodiment and so forth, the present disclosure is not limited to the above example embodiment. The configuration and details of the present disclosure can be changed in various manners that can be understood by one skilled in the art within the scope of the present invention.

### DESCRIPTION OF REFERENCE NUMERALS

- 1: operating device
- 10: substrate
- 11: electrode
- 20: key top
- 30: rubber
- 31: base part
- 32: lid part
- 33: support part
- 40: metal dome
- 50: CPU
- P: panel

## Claims

1. An operating device comprising:
an operating unit placed apart from a substrate, the operating unit being pressed and operated by a user;
a first elastic member placed in abutment on the substrate and the operating unit between the substrate and the operating unit, the first elastic member having a spaced portion formed apart from the substrate, the first elastic member deforming so that the spaced portion moves toward the substrate as a result that the operating unit is pressed and operated;
an electroconductive second elastic member on a surface facing the substrate of the spaced portion of the first elastic member, the second elastic member abutting on the substrate and deforming as a result that the operating unit is pressed and operated and the spaced portion moves toward the substrate;
an electrode provided on the substrate, the electrode generating capacitance with the second elastic member; and
a detecting unit detecting the capacitance generated on the electrode and accepting an operation corresponding to a detected value of the capacitance.

2. The operating device according to Claim 1, wherein
the second elastic member is configured to abut on the substrate as a result that the operating unit is pressed and operated and the spaced portion of the first elastic member moves toward the substrate, and deform as a result that the operating unit is then further pressed and operated and the spaced portion further moves toward the substrate.

3. The operating device according to Claim 2, wherein
the second elastic member is formed of a metal leaf spring and is configured so that the leaf spring deforms as a result that the operating unit is pressed and operated in a state where the second elastic member abuts on the substrate.

4. The operating device according to Claim 3, wherein
the second elastic member is formed in a dome shape opening toward the substrate.

5. The operating device according to Claim 2, wherein
the detecting unit accepts at least two operations in accordance with the detected value of the capacitance.

6. The operating device according to Claim 2, wherein
the detecting unit accepts at least two different operations in accordance with whether or not the detected value of the capacitance exceeds a preset threshold value.

7. The operating device according to Claim 2, wherein
the detecting unit detects the capacitance in a state where the user is close to or in contact with the operating unit and the second elastic member does not abut on the substrate, the capacitance in a state where the second elastic member abuts on the substrate, and the capacitance in a state where the second elastic member abuts on the substrate and then deforms, as being distinct from each other, and accepts operations different from each other in accordance with the detected values detected as being distinct from each other.
